# EUROPEAN PATENT APPLICATION

(11) **EP 1 944 388 A1**
(43) Date of publication of application: **16.07.2008**
(21) Application number: 06832416.9
(22) Date of filing: 02.11.2006
(51) Int. Cl.: C23C 14/35

(54) **MAGNET STRUCTURE FOR MAGNETRON SPUTTERING SYSTEM, CATHODE ELECTRODE UNIT AND MAGNETRON SPUTTERING SYSTEM**

(30) Priority: 04.11.2005 JP 2005321378
(71) Applicant: Shinmaywa Industries, Ltd., Takarazuka-shi, Hyogo 665-8550 (JP)
(72) Inventor: KONDO, Takahiko, 1-1, Shinmeiwa-cho, Takarazuka-shi Hyogo 665-8550 (JP); HORI, Takanobu, 1-1, Shinmeiwa-cho, Takarazuka-shi Hyogo 665-8550 (JP); IWASAKI, Yasukuni, 1-1, Shinmeiwa-cho, Takarazuka-shi Hyogo 665-8550 (JP); YONEYAMA, Nobuo, 1-1, Shinmeiwa-cho, Takarazuka-shi Hyogo 665-8550 (JP)
(74) Representative: Piésold, Alexander James
(86) International application number: PCT/JP2006/321950
(87) International publication number: WO 2007/052737

(57) **Abstract**

Provided are a magnet structure and the like capable of changing a magnetic force line distribution on a surface of a target to thereby achieve wide erosion of a target, using a simple drive mechanism. A magnet structure (110) comprises a main magnet (10, 13) disposed at a reverse surface (20B) side of a target (20) to produce a main magnetic force line reaching an obverse surface (20A) of the target, an adjustment magnet (11) disposed at the reverse surface (20B) side of the target (20) to produce an adjustment magnetic force line for changing a magnetic flux density distribution produced by the main magnetic force line, a magnetic path (21A, 21B, 24) of the adjustment magnetic force line which is disposed at the reverse surface (20B) side of the target 20, and a magnetic field adjustment means (12, 14) configured to be able to change strength of the adjustment magnetic force line passing through inside of the magnetic path (21A, 21B, 24).

## Description

### Technical Field

The present invention relates to a magnet structure and a cathode electrode unit for a magnetron sputtering system, and a magnetron sputtering system (hereinafter referred to as "magnet structure and the like"). More specifically, the invention relates to a technique for improving the magnet structure and the like for magnetron sputtering for the purpose of increasing target utilization efficiency.

### Background Art

A film formation method based on sputtering phenomenon in which ion (for example Ar ion) is caused to collide with a target material in a vacuum to cause atoms of the target to pop up from the target material and deposit on a substrate disposed opposite to the target material, is conventionally well-known.

According to a magnetron sputtering film formation method, which is one of methods based on the above sputtering phenomenon, a tunnel-shaped leakage magnetic field with a specified magnetic flux density or higher can be formed over a target surface (obverse surface opposite to a substrate) to capture secondary electrons generated during a process of the sputtering phenomenon by Lorentz force and cause the secondary electrons to conduct their cycloid motion, thereby increasing a frequency of ionization collision of the secondary electrons with Ar gas. Thereby, high-density plasma is produced in a space lying in the vicinity of the target surface, thereby making a film formation rate higher.

Such a magnetron sputtering film formation method, however, has a drawback that, because a target material in a stronger magnetic field is locally eroded faster by the sputtering, a sputtering amount in a plane of the target material becomes non-uniform, decreasing target utilization efficiency. For this reason, various techniques have thus far been developed to overcome this drawback.

For example, there has been proposed a drive mechanism for a magnet structure, which moves in a plane direction of a target surface an entire magnetic device (magnet structure) including a plurality of magnets for producing the aforesaid leakage magnetic field, yokes, and connecting members (see patent document 1).

Since the drive mechanism enables the magnet to move in the plane direction along a reverse surface of the target, it can change a magnetic force line distribution on the target surface in association with the movement of the magnet. As a result, an erosion promoting region on the target surface changes periodically with time, achieving uniform erosion on the target surface in sputtering.
Patent document 1: Japanese Laid-Open Patent Application Publication No. Hei. 4 - 329874 (Fig. 3)

### Disclosure of the Invention

### Problem to be Solved by the Invention

However, the drive mechanism for the magnet structure disclosed in the patent document 1 is required to drive the entire magnet structure, causing complexity and an increase in the size of the drive mechanism.

The present invention has been made under the circumstances, and an object of the present invention is to provide a magnet structure and the like which are capable of changing a magnetic force line distribution over a target surface with time to achieve wide erosion of the target with a simple drive mechanism, without moving the entire magnet structure.

### Means for Solving the Problem

To achieve the above described object, a magnet structure for a magnetron sputtering system of the present invention, comprises a main magnet disposed at a reverse surface side of a target to produce a main magnetic force line reaching an obverse surface of the target; an adjustment magnet disposed at the reverse surface side of the target to produce an adjustment magnetic force line for changing a magnetic flux density distribution of the main magnetic force line; a magnetic path of the adjustment magnetic force line which is disposed at the reverse surface side of the target; and a magnetic field adjustment means configured to be able to change strength of the adjustment magnetic force line passing through inside of the magnetic path.

In such a configuration, without moving the entire magnet structure and by using a simple drive mechanism, it becomes possible to change the strength of the adjustment magnetic force line passing through the inside of the magnetic path with time, and hence to change the main magnetic force line distribution (magnetic flux density distribution) over the obverse surface of the target, for example, in each specified cycle. As a result, wide erosion of the target can be achieved.

One example of the magnetic field adjustment means includes a movable element which is made of a magnetic material and is provided in a predetermined position with respect to the adjustment magnet; and a drive unit for driving the movable element to change the predetermined position.

In such a configuration, it becomes possible to achieve a simple drive mechanism which is able to periodically move only the movable element which is a part of the magnet structure.

It should be noted that the magnet structure may further comprise a plate-shaped base for holding the main magnet, the base being made of a magnetic material, and the magnetic path may be configured to include the base. Thereby, the base is effectively utilized as the magnetic path for guiding the adjustment magnetic force line.

The base may include a pair of an inner base and an outer base. The adjustment magnet may be sandwiched between the inner base and the outer base such that an orientation of a magnetic moment of the adjustment magnet conforms to a plane direction of the inner base and the outer base.

One example of the movable element is a plate-shaped member disposed to be opposed to a reverse surface side of the adjustment magnet.

By doing so, since there is an appropriate space on the reverse surface side of the adjustment magnet, it is expected that a distance between the movable element and the adjustment magnet can be easily changed.

The magnetic path may include a convex portion which is formed of a magnetic member and protrudes toward the reverse surface of the target. The convex portion may be disposed over the adjustment magnet in such a manner that both end surfaces of the convex portion are connected to the inner base and the outer base, respectively. One example of the convex portion is a member curved in an arch shape.

A cathode electrode unit for a magnetron sputtering system of the present invention, comprise a target made of a non-magnetic metal; and the aforesaid magnet structure which is disposed on a reverse surface side of the target; and a power supply source for supplying a specified electric power to the target.
Also, a magnetron sputtering system of the present invention comprises a vacuum chamber which accommodates the aforementioned cathode electrode unit and a substrate disposed opposite to the target of the cathode electrode unit, the vacuum chamber being configured to be able to reduce its internal pressure.

The above and further objects, features and advantages of the invention will more fully be apparent from the following detailed description with accompanying drawings.

### Effects of the Invention

According to the present invention, it is possible to provide a magnet structure and the like which are capable of changing a magnetic force line distribution over a surface of a target with time to thereby achieve wide erosion of the target, using a simple drive mechanism and without moving the entire magnet structure.

### Brief Description of Drawings

[Fig. 1] Fig. 1 is a plan view showing a cathode electrode unit including a magnet structure according to an embodiment 1 of the present invention;
[Fig. 2] Fig. 2 is a perspective view of the cathode electrode unit taken along line II-II of Fig. 1;
[Fig. 3] Fig. 3 is a view showing one exemplary result of analysis on the magnet structure according to the embodiment by a static magnetic field simulation technique;
[Fig. 4] Fig. 4 is a view showing one exemplary result of analysis on a magnet structure according to the embodiment by the static magnetic field simulation technique; and
[Fig. 5] Fig. 5 is a view showing one exemplary result of analysis on the magnet structure according to the embodiment by the static magnetic field simulation technique.

### Description of Reference Numerals

10 ... central permanent magnet
11... intermediate permanent magnet
12... movable element
13... outermost permanent magnet
14... actuator
20... target
21A... outer base
21B... inner base
22... first base piece
23... second base piece
24... curved magnetic member
24A... curved inner surface
24B... curved outer surface
25... upper magnetic force line
26... lower magnetic force line
26A... first lower magnetic force line
26B... second lower magnetic force line
27... inner intermediate magnetic force line
28... outer intermediate magnetic force line
29... zero point
100... cathode electrode unit
110... magnet structure
V1...electric power source
BM1, BM2... zero cross position

### Best Mode for Carrying Out the Invention

Hereinafter, a preferred embodiment of the present invention will be described with reference to the drawings.

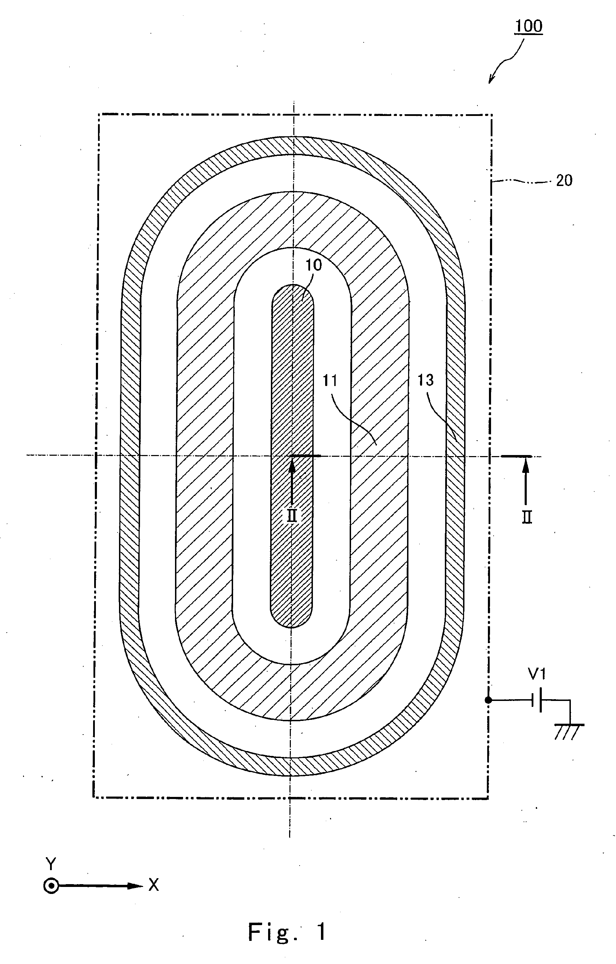

Fig. 1 is a plan view showing a cathode electrode unit including a magnet structure (i.e., magnetic field producing device) according to the embodiment of the present invention.

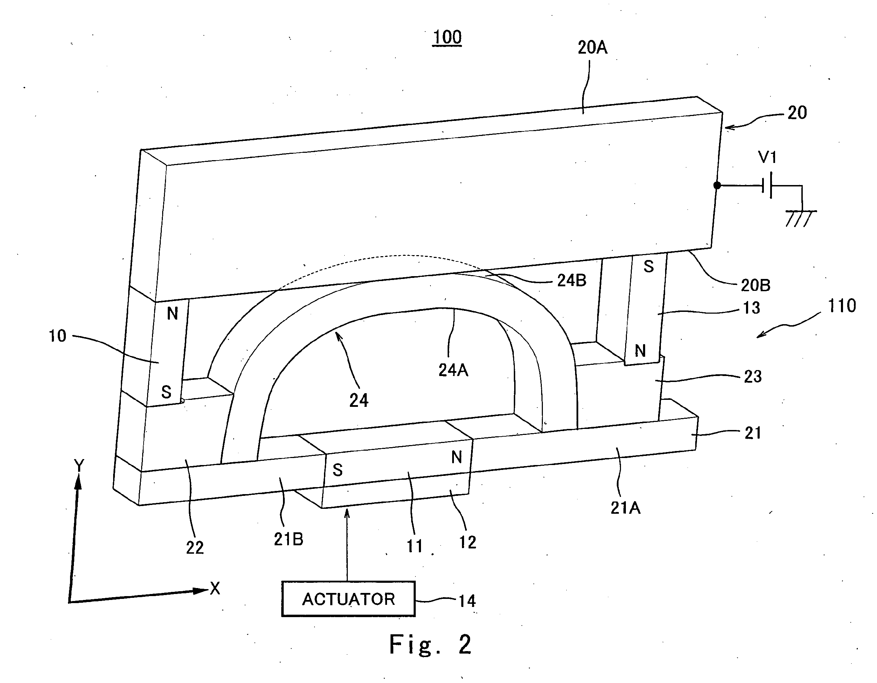

Fig. 2 is a perspective view of the cathode electrode unit taken along line II-II of Fig. 1.

For simplification of the drawing, Fig. 1 shows a cross-section of a magnet portion of a magnet structure 110.

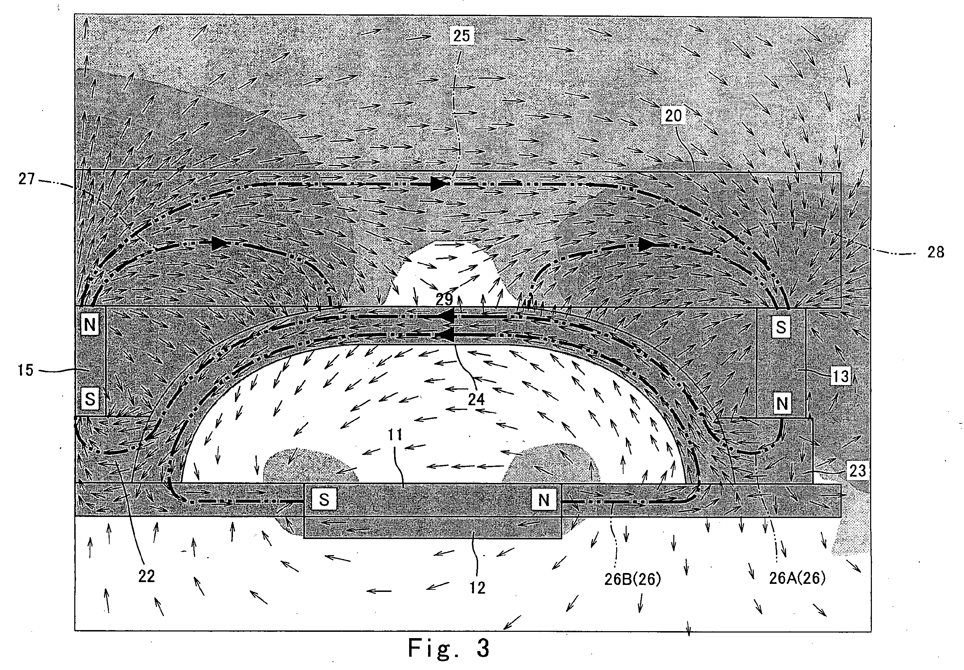

For convenience's sake, a width direction and a thickness direction of a target 20 are represented as X-direction and Y-direction, respectively, in Figs. 1 and 2 (as well as in Fig. 3) for description of components of the cathode electrode unit 100.

Further, although the components of the magnet structure 110 are shown as being cut to a predetermined thickness in a depth direction (perpendicular to both the X-direction and the Y-direction) in Fig. 2, these components actually extend in the depth direction to have the same sectional shapes. This can be easily understood from Fig. 1.

According to the present embodiment, as shown in Fig. 2, the cathode electrode unit 100 comprises as major components thereof, the rectangular target 20 made of a non-magnetic metal such as aluminum (A1), and the magnet structure 110 having plural magnets and positioned at a reverse surface 20B side of the target 20.

The target 20 is a parent material of a thin film to be coated over a substrate (not shown) positioned opposite to the target 20, and is supplied with an electric power from an electric power source V1 so as to serve as a cathode for the purpose of attracting Ar ion (positive ion) present in plasma.

In this embodiment, a vacuum chamber (not shown) for magnetron sputtering, which accommodates the cathode electrode unit 100 and the substrate therein and which is capable of reducing an internal pressure thereof, is grounded as an anode.

During a sputtering phenomenon, high-density plasma containing Ar ion is generated in the vicinity of the obverse surface of the target 20 by a tunnel-shaped leakage magnetic field for plasma confinement, while atoms forming the target 20 (i.e., aluminum atoms in the present embodiment) are beaten out of the obverse surface of the target by collision energy of Ar ion and deposited on the substrate. Since such a technique is well known in the art, detailed description thereof is herein omitted.

As shown in Fig. 2, the magnet structure 110 includes a pair of an outer base 21A and an inner base 21B which are made of ferromagnetic stainless or iron.

The outer base 21A is, in a plan view, defined by an outer peripheral surface having a dimension substantially equal to a outside dimension of the target 20 and an inner peripheral surface having a dimension substantially equal to an outside dimension of the intermediate permanent magnet 11 (to be described later) of a plate-shape and an annularly elongated-circle shape to allow the intermediate permanent magnet 11 to be fitted to the inner peripheral surface of the outer base 21A. As a result, the outer base 21A has an annularly plate-shape having an elongate hole.

The inner base 21B has an elongate-circle plate shape to be fitted to the elongate-circle hole of the intermediate permanent magnet 11 in a plan view.

Magnets and magnetic members (to be described in detail later) are disposed on each of the inner base 21B and the outer base 21A for producing a tunnel-shaped leakage magnetic field for plasma confinement in a space extending above and in the vicinity of the obverse surface 20A of the target 20.

Actually, the components (including the inner base 21B and the outer base 21A, the magnets and the magnetic member) of the magnet structure 110 and the target 20 are fixed to each other integrally by appropriate fixing device. But, illustration and description of such fixing device are herein omitted.

As shown in Figs. 1 and 2, the magnet structure 110 includes, as a first main magnet, a central permanent magnet 10 (i.e., internal magnet) of a substantially rectangular shape positioned at the reverse surface 20B side of the target 20 in a center position in the width direction (i.e., X-direction) of the target 20. The central permanent magnet 10 is shaped like a rod with its longitudinal center line coinciding with the longitudinal center line of the target 20 in a plan view and is placed on an upper surface of a first base piece 22 resting on the inner base 21B shown in Fig. 2.

The central permanent magnet 10 has north and south poles producing a magnetic moment oriented in the direction opposite to the Y-direction (i.e., the direction from the obverse surface 20A toward the reverse surface 20B of the target 20), as shown in Fig. 2. The central permanent magnet 10 is opposed to a center portion of the inner base 21B with the first base piece 22 interposed therebetween in a state where north-pole of the central permanent magnet 10 is in contact with a center portion of the reverse surface 20B of the target 20, while the south-pole of the central permanent magnet 10 is in contact with an upper surface of the first base piece 22 made of a magnetic material (e.g., ferromagnetic stainless or iron).

As shown in Figs. 1 and 2, the magnet structure 110 includes, as a second main magnet, an outermost permanent magnet 13 (i.e., outer magnet) of a substantially elongate cylindrical shape positioned at the reverse surface 20B side of the target 20 inwardly of and in the vicinity of an end portion of the target 20 lying in the width direction (i.e., X-direction) of the target 20. The outermost permanent magnet 13 has an annular shape extending along the periphery of the end portion of the target 20 in a plan view and is placed on an upper surface of a second base piece 23 resting on the outer base 21A shown in Fig. 2.

The outermost permanent magnet 13 has north and south poles producing a magnetic moment oriented in the Y-direction within the outermost permanent magnet 13 (i.e., the direction from the reverse surface 20B of the target 20 toward the obverse surface 20A of the target 20), as shown in Fig. 2. The outermost permanent magnet 13 is opposed to a peripheral portion of the outer base 21A with the second base piece 23 interposed therebetween in a state where the south-pole of the outermost permanent magnet 13 is in contact with a peripheral portion of the reverse surface 20B of the target 20, and the north-pole of the outermost permanent magnet 13 is in contact with an upper surface of the second base piece 23 made of a magnetic material (e.g., ferromagnetic stainless or iron).

As shown in Figs. 1 and 2, the magnet structure 110 includes, as an adjustment magnet, an intermediate permanent magnet 11 of an annularly elongate-circle plate shape in a plan view positioned at the reverse surface 20B side of the target 20. The intermediate permanent magnet 11 is located between the central permanent magnet 10 and the outermost permanent magnet 13 and is positioned at a substantially center portion of the target 20 in the X-direction of the target 20. The intermediate permanent magnet 11 is sandwiched between the inner base 21B and the outer base 21A.

Since the central permanent magnet 11 has a thickness substantially equal to those of the inner base 21B and the outer base 21A as shown in Fig. 2, there is no step between the central permanent magnet 11, and the inner base 21B and the outer base 21A. Therefore, the members 21A, 21B, and 11 are integral with each other to form a single rectangular member in a surface configuration.

The intermediate permanent magnet 11 has north and south poles producing a magnetic moment oriented in the direction opposite to the X-direction within the intermediate permanent magnet 11 (i.e., the direction from the end portion of the target 20 to the center portion of the target 20), as shown in Fig. 2. The south-pole of the intermediate permanent magnet 11 is in contact with the outer peripheral surface of the inner base 21B, while the north-pole of the intermediate permanent magnet 11 is in contact with the inner peripheral surface of the outer base 21A. That is, the inner base 21B and the outer base 21A are configured to sandwich the intermediate permanent magnet 11 therebetween such that the orientation of the magnetic moment within the intermediate permanent magnet 11 conforms to the plane direction of the inner base 21B and the outer base 21A.

The permanent magnets 10, 11, and 13 described above can be constructed using various known magnet materials. In cases where these permanent magnets 10, 11, and 13 are used as being immersed in cooling water for cooling, the reverse surface 20B of the target 20, it is desirable to provide the surfaces of the magnets with a rust-proof treatment or select a rust-proof material (e.g., ferrite magnet).

The curved magnetic member 24 (convex-shaped ferromagnetic member), which is made of a magnetic material such as ferromagnetic stainless or iron, is curved like a bow (or arch). As shown in Fig. 2, the curved magnetic member 24 has end surfaces extending in parallel with the reverse surface 20B of the target 20 in such a manner that one end surface thereof contacts the surface of the inner base 21B and the other end surface thereof contacts the surface of the outer base 21A. Thus, the curved magnetic member 24 bridges the inner base 21B and the outer base 21A over the intermediate permanent magnet 11.

The curved magnetic member 24 is of a substantially annularly elongate-circle shape in a plan view. More specifically, the curved magnetic member 24 has curved inner and outer surfaces 24A and 24B which are curved at equal curvature convexly toward the reverse surface 20B of the target 20 in the thickness direction (i.e., Y-direction) of the target 20. The curved magnetic member 24 is in the form of a half obtained by cutting an imaginary annular cylindrical body having a substantially elongate-circle section into halves along the end surfaces so that a dimension between the curved inner and outer surfaces 24A and 24B corresponds to a wall thickness of the annular cylindrical body.

Furthermore, one of both ends in the X-direction of the curved outer surface 24B of the curved magnetic member 24 is in contact with the side surface of the first base pipe 22, while the other end is in contact with the side surface of the second base piece 23.

In this manner, the curved magnetic member 24 and a part of the inner base 21B and the outer base 21A (to be precise, portions of the inner base 21B and the outer base 21A which are respectively located between the magnetic poles of the central permanent magnet 11 and the end surfaces of the curved magnetic member 24) form a magnetic path of adjustment magnetic force lines produced by the intermediate permanent magnet 11. This makes it possible to make use of the inner base 21B and the outer base 21A as the magnetic path for guiding the second lower magnetic force line 26B. Thus, effective use of the magnetic member is achieved.

The magnetic path is configured to confine and guide the adjustment magnetic force line so that the magnetic force line emanating from the north pole of the intermediate permanent magnet 11 returns to the south pole of the intermediate permanent magnet 11. A specific structure of the adjustment magnetic force line will be described in detail later.

The top of the curved outer surface 24B in the Y-direction may be in contact with the reverse surface 20B of the target 20 or may be spaced apart from the reverse surface 20B by an appropriate clearance (not shown).

When the above two are in contact with each other, the distance between the target 20 and the intermediate permanent magnet 11 is shortened so that magnetic energy contributing to the production of a magnetic field for plasma confinement, which is generated by the magnet 11 works effectively.

When the appropriate clearance is provided between the two, there is sometimes an advantage that reverse surface 20B of the target 20 is cooled with cooling water. For example, in cases where such a cooling structure is employed in which the magnet structure 110 is entirely immersed in cooling water stored in a cooling water vessel (not shown), the cooling water is flowed in the clearance, so that efficient heat exchange between the cooling water and the reverse surface 20B of the target 20 is suitably carried out. In cases where such a cooling structure is employed in which a rectangular hollow backing plate (not shown) for passage of cooling water is in contact with the reverse surface 20B of the target 20, such a clearance is indispensable as a space into which the backing plate is inserted.

As components for a magnetic field adjustment device which is capable of changing strength of adjustment magnetic force line produced by the intermediate permanent magnet 11, there are a movable element 12 which is made of a magnetic material (e.g., ferromagnetic stainless or iron) and is provided in a predetermined position with respect to the intermediate permanent magnet 11, and an actuator (drive unit) 14 for driving the movable element 12 to change the predetermined position.

The movable element 12 has a shape having an outer dimension equal to that of the intermediate permanent magnet 11 in a plan view. As shown in Fig. 2, the movable element 12 extending along the intermediate permanent magnet 11 in a plan view is disposed opposite to and in contact with the reverse surface of the intermediate permanent magnet 11.

By positioning the movable element 11 opposite to the reverse surface side of the intermediate permanent magnet 11, there is formed an appropriate space on the reverse surface side of the intermediate permanent magnet 11. This can easily change a distance between the movable element 12 and the intermediate permanent magnet 11.

In addition, based on control of suitable control device (microprocessor or the like: not shown), the actuator 14 is able to move the movable element 12 in each predetermined cycle from a state where the movable element 12 and the intermediate permanent magnet 11 are in contact with each other to a state where they are apart a predetermined distance in, for example, downward direction (direction opposite to Y-direction) from each other.

As a matter of course, the movable element 11 may be shifted periodically in X-direction by the actuator 14, or a movement start timing or a movement speed of the movable element 11 may be determined based on a sputtering state of the target 20.

Description will be made of a result of analysis of a magnetic flux density distribution over the above-described target 20 magnetized, by making use of a static magnetic field simulation technique.

An analytical model having substantially the same shape as shown in Fig. 2 is mesh-divided into unit analytical areas for numerical calculation, and is created on a computer. Appropriate physical property data on respective materials and boundary condition data have been input to mesh areas corresponding to the respective components of the magnet structure 110, mesh area corresponding to the target 20 and boundary mesh areas.

As an analytical solver, general-purpose magnetic field analysis software ("MagNet" manufactured by INFOLYTICA CORPORATION) has been used.

Figs. 3, 4 and 5 are views each showing one exemplary result of analysis on the magnet structure according to the present embodiment by the static magnetic field simulation technique.

Fig. 3 is a view showing a magnetic flux density distribution (constant-height surfaces) and magnetic flux density vectors (indicated by arrows) in the analytical model, and an analysis result view of a two dimensional cross-section taken along II-II in Fig. 1.

Note that illustration of magnetic flux density vectors within the magnets 10, 11, and 13 is omitted here.

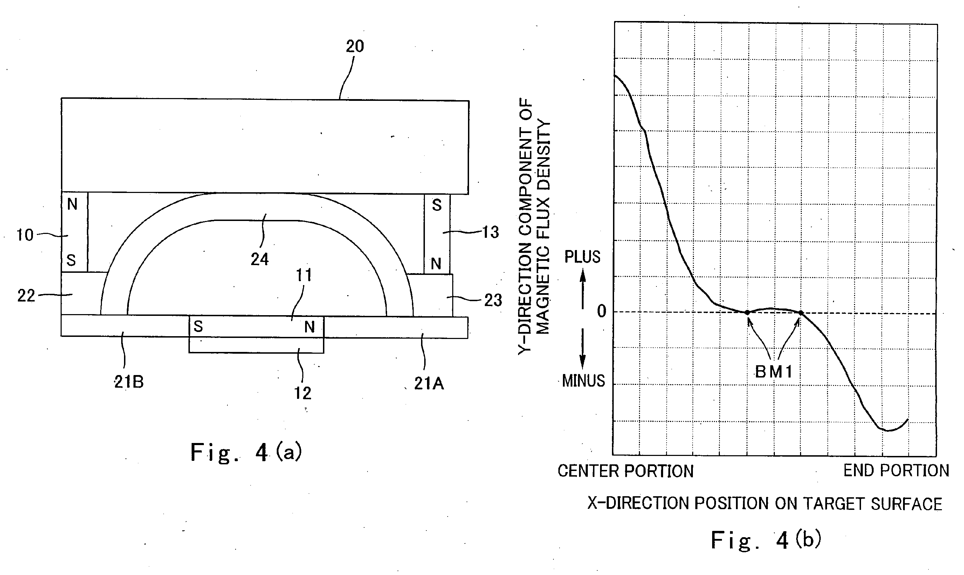

In Fig. 4(b), a horizontal axis represents a X-direction position on the target surface and a vertical axis represents a Y-direction component of magnetic flux density on the target surface, and the relationship between the two is plotted using numerical data obtained from the result of analysis. Fig. 4(b) shows an analysis result obtained when the movable element 12 and the central permanent magnet 11 are made in contact with each other as shown in Fig. 4(a).

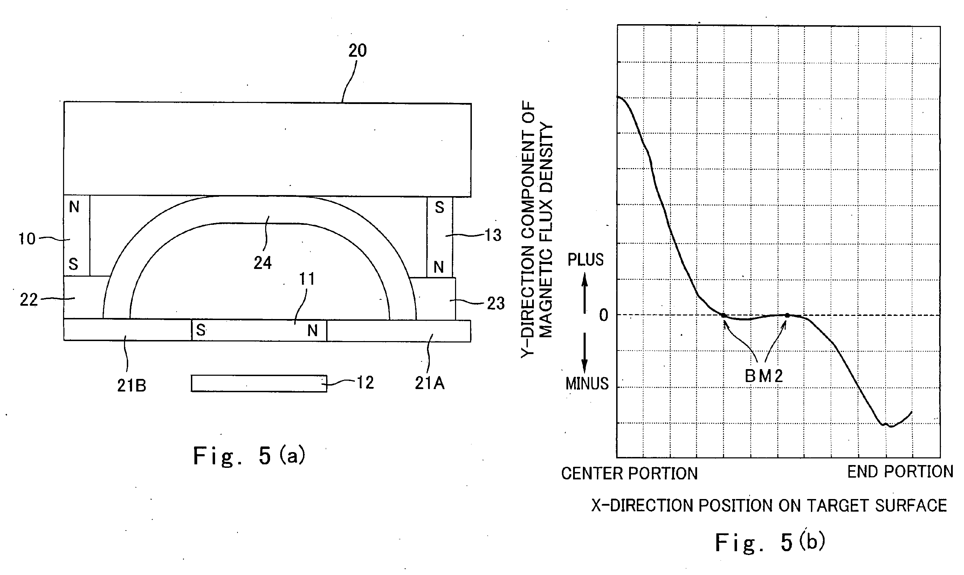

In Fig. 5(b), a horizontal axis represents the X-direction position on the target surface and the vertical axis represents the Y-direction component of magnetic flux density on the target surface, and the relationship between the two is plotted using numerical data obtained from the result of analysis. Fig. 5(b) shows an analysis result obtained when the movable element 12 and the central permanent magnet 11 are apart a predetermined distance from each other as shown in Fig. 5(a).

A gray-scale magnetic flux density contour figure (constant-height view) shown in Fig. 3 represents a high-low distribution of a total (absolute value) of vector components of the magnetic flux density (i.e., magnetic flux density distribution). The contour view shows that the magnetic flux density rises with transition from a lighter gray region to a deeper gray region (It should be noted that the upper limit of magnetic flux density is set to 500 G).

As can be seen from such magnetic flux density contour figure and vector view, a magnetic force line as a curve on which the tangential direction at each point coincides with the magnetic field direction at that point is understood.

Fig. 3 shows the magnetic flux density contour figure and vector view in accordance with those output from the analytical computer. For easy understanding of these views; however, Fig. 3 simplifies the magnetic flux density distribution output from the computer while adding bold apparent two-dotted lines representing each of an upper magnetic force line 25, a lower magnetic force line 26 (first lower magnetic force line 26A and second lower magnetic force line 26B), an inner intermediate magnetic force line 27 and an outer intermediate magnetic force line 28.

According to Fig. 3, the upper magnetic force line 25 and the lower magnetic force line 26 (first lower magnetic force line 26A and second lower magnetic force line 26B) are produced so as to cancel each other's X-direction vector component of magnetic flux density (component in the width direction of the target 20) within the target 20, while the inner intermediate magnetic force line 27 and the outer intermediate magnetic force line 28 are produced so as to cancel each other's Y-direction vector component of magnetic flux density (component in the thickness direction of the target 20) within the target 20.

Specifically, the upper magnetic force line (main magnetic force line) 25 emanates from the north pole of the central permanent magnet 10, reaches the obverse surface 20A of the target 20, extends substantially in parallel with the X-direction in an inside portion of the target 20 that lies just above a zero point 29 at which the Y-direction vector component of magnetic flux density and the X-direction vector component of magnetic flux density become substantially zero, and enters the south pole of the outermost permanent magnet 13 while curving like an arch within the target 20.

The lower magnetic force line 26 includes the first lower magnetic force line 26A and the second lower magnetic force line 26B (adjustment magnetic force line) to be described below.

The first lower magnetic force line 26A emanates from the north pole of the outermost permanent magnet 13, passes through the second base piece 23, extends substantially in parallel in the direction opposite to the X-direction while being confined inside the curved magnetic member 24 located just below the zero point 29, passes through the first base piece 22 while bending like an arch to conform to the shape of the curved magnetic member 24, and enters the south pole of the central permanent magnet 10.

The second lower magnetic force line 26B is a magnetic force line whose strength is changed according to the movement of the movable element 12 to be described later. The second lower magnetic force line 26B emanates from the north pole of the intermediate permanent magnet 11, passes through the outer base 21A, extends substantially in parallel in the direction opposite to the X-direction while being confined inside the curved magnetic member 24 located just below the zero point 29, passes through the inner base 21B while bending like an arch to conform to the shape of the curved magnetic member 24, and returns to the south pole of the intermediate permanent magnet 10.

The second lower magnetic force line 26B, and the magnetic force line passing through inside of the intermediate permanent magnet 11 form an annular magnetic circuit.

The inner intermediate magnetic force line 27 emanates from the north pole of the central permanent magnet 10, reaches an intermediate point in the thickness direction of the target 20, extends to bend like an arch within the target 20, passes through a portion of the target 20 that lies beside the zero point 29 (location on the minus side in the X-direction with respect to the zero point 29) substantially in parallel with the direction opposite to the Y-direction, and enters the curved magnetic member 24.

The outer intermediate magnetic force line 28 emanates from the curved magnetic member 24, passes through the portion of the target 20 that lies beside the zero point 29 (location on the plus side in the X-direction with respect to the zero point 29) substantially in parallel with the Y-direction, reaches an intermediate point in the thickness direction of the target 20, extends to bend like an arch within the target 20, and enters the south pole of the outermost permanent magnet 13.

As shown in Fig. 3, the zero point 29 is formed in a region surrounded by the magnetic force lines 25, 26, 27, and 28. Herein, the zero point 29 is present in the vicinity of a contact point between the reverse surface 20B of the target 20 and the top of the curved magnetic member 24.

By thus positioning the zero point 29 at a location optimum to the constitution of the target 20 (thickness, material and the like), it is possible to correctly adjust the leakage magnetic field for plasma confinement produced over the obverse surface 20A of the target 20.

To be more specific, the magnetic flux density component (hereinafter referred to as "parallel magnetic flux density") parallel (X-direction) to the obverse surface 20A, in the leakage magnetic field in the vicinity of the obverse surface 20A which leaks to the obverse surface 20A of the target 20, serves as the leakage magnetic field for plasma confinement.

The magnet structure 110 described above is capable of maintaining the parallel magnetic flux density to a value not less than a predetermined magnetic flux density BS (e.g., 200 to 300 G) over substantially the entire X-direction region of the obverse surface 20A of the target 20. As a result, efficient and wide erosion of the target 20 can be achieved advantageously.

Further, it is empirically known that a target portion maintaining the magnetic flux density component (hereinafter referred to as "perpendicular magnetic flux density") perpendicular (Y-direction) to the obverse surface 20A to near zero in the leakage magnetic field is eroded faster by sputtering.

The magnet structure 110 is able to correctly form the zero cross position (e.g., positions of BM1 In Fig. 4(b) and BM2 in Fig. 5) at which the perpendicular magnetic flux density becomes approximately zero in the X-direction of the obverse surface 20A of the target 20. As a result, the magnet structure 110 enables effective utilization of magnetic energy and wide erosion of the target 20 advantageously.

Thus, the magnet structure 110 according to the present embodiment is capable of producing a quadridirectional magnetic field comprising the upper magnetic force line 25, the lower magnetic force line 26 (first lower magnetic force line 26A and second lower magnetic force line 26B), the inner intermediate magnetic force line 27 and the outer intermediate magnetic force line 28 which surround the zero point 29 existing at a suitable location in the target 20 (for example, a location in the vicinity of the reverse surface 20B). Therefore, the magnet structure 110 makes it possible to realize wide erosion with localized sputtering of the target 20 suppressed, thereby to increase the target utilization efficiency, hence, prolong the change period of the target 20. Thus, the magnet structure 110 can contribute to an improvement in the operating efficiency of a planar-type magnetron sputtering system.

As shown in Figs. 4 and 5, by changing the distance between the movable element 12 and the intermediate permanent magnet 11 periodically, it becomes possible to periodically change the X-direction position (hereinafter referred to as "zero cross position") on the obverse surface 20A of the target 20 at which the perpendicular magnetic flux density becomes approximately zero.

To be specific, by making the movable element 12 contact (as shown in Fig. 4) the intermediate permanent magnet 11 apart from the movable element 12 (as shown in Fig. 5), a part of the magnetic force line emanating from the intermediate permanent magnet 11 is shortened, thereby resulting in the change of a strength of the second lower magnetic force line 26B (adjustment magnetic force line) passing through the inside of the inner base 21B and the outer base 21A as the magnetic path.

Thereby, the magnetic flux density distribution of the upper magnetic force line 25 (main magnetic force line) over the obverse surface 20A of the target 20 changes. Therefore, it can be estimated that the zero cross positions BM2 at two points at which the perpendicular magnetic flux density becomes approximately zero in the state of Fig. 5(state where the movable element 12 and the intermediate permanent magnet 11 are apart from each other) are moved periodically along the obverse surface 20 of the target 20 in X-direction (direction from the center portion of the target 20 to the end portion of the target 20), as shown by the zero cross positions BM1 at two points at which the perpendicular magnetic flux density becomes approximately zero in Fig. 4 (state where the movable element 12 and the intermediate permanent magnet 11 are in contact with each other).
As should be appreciated, according to the magnet structure 110 of this embodiment, using the simple drive mechanism which moves only the movable element 12 which is a part of the magnet structure 110, relative to the intermediate permanent magnet 11 with time and without moving the entire magnet structure 110, it becomes possible to change with time the strength of the second lower magnetic force line 26B (adjustment magnetic force line) passing through the inside of the curved magnetic member 24, and hence to change the magnetic force line distribution (magnetic flux density distribution) over the obverse surface 20A of the target 20, for example, in each specified cycle. As a result, wide erosion of the target 20 can be achieved.

It will be apparent from the foregoing description that many improvements and other embodiments of the present invention may occur to those skilled in the art. Therefore, the foregoing description should be construed as an illustration only and is provided for the purpose of teaching the best mode for carrying out the present invention to those skilled in the art. The details of the structure and/or the function of the present invention can be modified substantially without departing from the spirit of the present invention.

### Industrial Applicability

The magnet structure according to the present invention is useful as, for example, magnetic field producing device for use in a magnetron sputtering system.

## Claims

1. A magnet structure for a magnetron sputtering system, comprising:
a main magnet disposed at a reverse surface side of a target to produce a main magnetic force line reaching an obverse surface of the target;
an adjustment magnet disposed at the reverse surface side of the target to produce an adjustment magnetic force line for changing a magnetic flux density distribution of the main magnetic force line;
a magnetic path of the adjustment magnetic force line which is disposed at the reverse surface side of the target; and
a magnetic field adjustment means configured to be able to change strength of the adjustment magnetic force line passing through inside of the magnetic path.

2. The magnet structure according to claim 1,
wherein the magnetic field adjustment means includes:
a movable element which is made of a magnetic material and is provided in a predetermined position with respect to the adjustment magnet; and
a drive unit for driving the movable element to change the predetermined position.

3. The magnet structure according to claim 2, further comprising:
a plate-shaped base for holding the main magnet, the base being made of a magnetic material;
wherein the magnetic path is configured to include the base.

4. The magnet structure according to claim 3,
wherein the base includes a pair of an inner base and an outer base;
and wherein the adjustment magnet is sandwiched between the inner base and the outer base such that an orientation of a magnetic moment of the adjustment magnet conforms to a plane direction of the inner base and the outer base.

5. The magnet structure according to claim 4,
wherein the movable element is a plate-shaped member disposed to be opposed to a reverse surface side of the adjustment magnet.

6. The magnet structure according to claim 4,
wherein the magnetic path includes a convex portion which is formed of a magnetic member and protrudes toward the reverse surface of the target;
and wherein the convex portion is disposed over the adjustment magnet in such a manner that both end surfaces of the convex portion are connected to the inner base and the outer base, respectively.

7. The magnet structure according to claim 6,
wherein the convex portion is curved in an arch shape.

8. A cathode electrode unit for a magnetron sputtering system, comprising:
a target made of a non-magnetic metal; and
the magnet structure according to any one of claims 1 to 7, which is disposed on'the reverse surface side of the target;
a power supply source for supplying a specified electric power to the target.

9. A magnetron sputtering system comprising:
a vacuum chamber which accommodates the cathode electrode unit according to claim 8 and a substrate disposed opposite to the target of the cathode electrode unit, the vacuum chamber being configured to be able to reduce its internal pressure.
